(19) **Europäisches Patentamt / European Patent Office / Office européen des brevets**

(11) **EP 4 068 933 A1**

(12) # EUROPEAN PATENT APPLICATION
published in accordance with Art. 153(4) EPC

(43) Date of publication:
**05.10.2022 Bulletin 2022/40**

(21) Application number: **21908084.3**

(22) Date of filing: **16.04.2021**

(51) International Patent Classification (IPC):
***H05K 7/20*** *(2006.01)*

(52) Cooperative Patent Classification (CPC):
Y02D 10/00

(86) International application number:
**PCT/CN2021/087911**

(87) International publication number:
**WO 2022/165993 (11.08.2022 Gazette 2022/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.02.2021 CN 202110144840**

(71) Applicant: **Wingtech Technology (Shenzhen) Co., Ltd.**
**Shenzhen, Guangdong 518000 (CN)**

(72) Inventor: **TAO, Jianyun**
**Shenzhen City, Guangdong 518000 (CN)**

(74) Representative: **Grünecker Patent- und Rechtsanwälte**
**PartG mbB**
**Leopoldstraße 4**
**80802 München (DE)**

(54) **HEAT DISSIPATION ELEMENT AND ELECTRONIC DEVICE**

(57) Embodiments of the disclosure provide a heat dissipation element and an electronic device, and relate to the technical field of heat dissipation. The heat dissipation element includes a body frame, inner ribs and outer ribs, the body frame encloses an inner space, the inner ribs are connected with the body frame and divide the inner space into a plurality of heat dissipation holes, and the outer ribs are connected with the body frame and extend in a direction away from the inner space. The embodiments of the disclosure may diffuse heat from a center to an edge, which is beneficial for improving a heat dissipation capacity.

FIG. 2

## Description

### CROSS REFERENCE TO RELEVANT APPLICATIONS

The present disclosure claims the priority to Chinese patent application filed on February 2nd, 2021 before the Chinese Patent Office with the application number of 2021101448405 and the title of "HEAT DISSIPATION ELEMENT AND ELECTRONIC DEVICE", which is incorporated herein in its entirety by reference.

### TECHNICAL FIELD

The present disclosure relates to the technical field of heat dissipation, and more particularly, to a heat dissipation element and an electronic device.

### BACKGROUND

With the increasingly improved performances of an electronic product, a frequency and power consumption of a chip of the electronic product are higher. Taking a central processing unit (CPU) as an example, heat production and a frequency of the CPU are in direct proportion. If heat is not radiated in time, a working performance of the CPU can be reduced, and even permanent hardware damage may be caused. In some electronic products (such as a router and an acoustic enclosure) with a small volume and a certain heat dissipation space, a rib with a high heat conductivity is often added to improve a heat dissipation effect, but a heat transfer effect is limited, so that increasing heat dissipation requirements cannot be satisfied.

### SUMMARY

The present disclosure aims to provide a heat dissipation element and an electronic device, which may diffuse heat from a center to an edge, thus being beneficial for improving a heat dissipation capacity.

The embodiments of the present disclosure are realized as follows.

The embodiments of the present disclosure provide a heat dissipation element, which includes a body frame, inner ribs and outer ribs, wherein the body frame encloses an inner space, the inner ribs are connected with the body frame and divide the inner space into a plurality of heat dissipation holes, and the outer ribs are connected with the body frame and extend in a direction away from the inner space.

Optionally, the inner ribs are provided at multi levels, each level of inner rib is arranged in the inner space and divides the inner space into the plurality of heat dissipation holes, wherein an $(n+1)^{th}$ level of inner rib is arranged in a heat dissipation hole enclosed by an $n^{th}$ level of inner rib and the inner space, wherein $n$ is a positive integer.

Optionally, each level of inner rib includes a first rib and a second rib arranged in a crossed way, and each first rib and each second rib are connected with a higher-level inner rib or the body frame.

Optionally, a thickness of the inner rib satisfies the following formula:

$$D_j = D_1 * k^{j-1}$$

wherein $D_j$ represents a thickness of a $j^{th}$ level of inner rib, $1 \leq j \leq n + 1$, $D_1$ represents a thickness of a first level of inner rib, and $k$ is a constant less than 1.

Optionally, a range of $k$ is that $1/3 < k < 2/3$.

Optionally, the outer ribs are provided at multi levels, a first level of outer rib is connected with the body frame and extends in a direction away from the body frame, an $(m+1)^{th}$ level of outer rib is connected with one end of an $m^{th}$ level of outer rib far away from the body frame, and the $(m+1)^{th}$ level of outer rib and the $m^{th}$ level of outer rib are arranged in a way of forming an angle, wherein $m$ is a positive integer.

Optionally, multiple $m^{th}$ level of outer ribs are provided, each $m^{th}$ level of outer rib is connected with two $(m+1)^{th}$ level of outer ribs, and angles formed by the two $(m+1)^{th}$ level of outer ribs and the $m^{th}$ level of outer rib are equal.

Optionally, a length of the outer rib satisfies the following formula:

$$L_i = L_1 * A^{i-1}$$

wherein $L_i$ represents a length of an $i^{th}$ level of outer rib, $1 \leq i \leq m + 1$, $L_1$ represents a length of a first level of outer rib, and $A$ is a constant.

Optionally, a range of $A$ is that $1/2 < A < 1$.

Optionally, a thickness of the outer rib satisfies the following formula:

$$D_i = D_1 * B^{i-1}$$

wherein $D_i$ represents a thickness of an $i^{th}$ level of outer rib, $1 \leq i \leq m + 1$, $D_1$ represents a thickness of a first level of outer rib, and $B$ is a constant less than 1.

Optionally, a range of $B$ is that $1/3 < B < 2/3$.

Optionally, an angle formed by the $(m+1)^{th}$ level of outer rib and the $m^{th}$ level of outer rib satisfies the following formula:

$$\alpha \geq (180 - 360/C)°$$

wherein $a$ represents the angle formed by the $(m+1)^{th}$ level of outer rib and the $m^{th}$ level of outer rib, $C$ represents a number of the $(m+1)^{th}$ level of outer rib.

Optionally, a shape of the body frame is similar to a shape of a body of a heat generating part.

Optionally, the body frame is approximately formed as a ring.

Optionally, the body frame is approximately formed as a circular ring, and the inner space enclosed by the body frame is correspondingly formed as a circle.

The embodiments of the present disclosure provide an electronic device, which includes the heat dissipation element according to any one of the embodiments above.

Optionally, a substrate plate is arranged on the body frame, and the substrate plate is connected with the body frame and covers the plurality of heat dissipation holes.

Optionally, an interface material with a high heat conductivity is coated on a heat generating part of the electronic device.

Optionally, a bottom surface of the substrate plate is contacted with the heat generating part through the interface material coated on the heat generating part.

Optionally, the interface material is a heat conductive silicone grease or a liquid metal.

## BRIEF DESCRIPTION OF THE DRAWINGS

In order to illustrate the technical solutions of the embodiments of the present disclosure more clearly, the drawings which need to be used in the embodiments will be briefly introduced hereinafter. It is to be understood that the following drawings only show some embodiments of the present disclosure, so that the drawings should not be regarded as limiting the scope. Those of ordinary skills in the art may further obtain other related drawings according to these drawings without going through any creative work.

FIG. 1 is a schematic diagram of connection between a heat dissipation element provided by an embodiment of the present disclosure and a heat generating part of an electronic device;
FIG. 2 is a schematic structural diagram of the heat dissipation element provided by the embodiment of the present disclosure;
FIG. 3 is a schematic structural diagram of the heat dissipation element in FIG. 2 from another perspective;
FIG. 4 is a schematic structural diagram of an inner rib provided by an embodiment of the present disclosure;
FIG. 5 is a schematic diagram of a recurrence relation of inner ribs at multi levels provided by an embodiment of the present disclosure; and
FIG. 6 is a schematic diagram of a recurrence relation of outer ribs at multi levels provided by an embodiment of the present disclosure.

Reference numerals: 100 refers to heat dissipation element; 110 refers to body frame; 120 refers to inner rib; 121 refers to first rib; 122 refers to second rib; 130 refers to outer rib; 140 refers to substrate plate; and 200 refers to heat generating part.

## DETAILED DESCRIPTION OF THE EMBODIMENTS

In order to make the objects, technical solutions, and advantages of the embodiments of the present disclosure clearer, the technical solutions in the embodiments of the present disclosure will be described clearly and completely hereinafter with reference to the drawings in the embodiments of the present disclosure. Obviously, the described embodiments are some, but not all, embodiments of the present disclosure. Generally, the assemblies in the embodiments of the present disclosure described and illustrated in the drawings herein may be arranged and designed in various different configurations.

Therefore, the following detailed descriptions of the embodiments of the present disclosure provided in the drawings are not intended to limit the scope of the present disclosure sought to be protected, but only represent the selected embodiments of the present disclosure. Based on the embodiments of the present disclosure, all other embodiments obtained by those of ordinary skills in the art without going through any creative work should fall within the scope of protection of the present disclosure.

It should be noted that: similar reference numerals and letters indicate similar items in the following drawings, so once one item is defined in one drawing, it does not need to be further defined and explained in the following drawings.

In the description of the present disclosure, it should be noted that if the orientation or position relationship indicated by the terms "center", "upper", "lower", "left", "right", "vertical", "horizontal", "inner", "outer", and the like is based on the orientation or position relationship shown in the accompanying drawings, or the orientation or position relationship of the product of the present disclosure in use, it is only for the convenience of description of the present disclosure and simplification of the description, and it is not to indicate or imply that the indicated device or element must have a specific orientation, and be constructed and operated in a specific orientation. Therefore, the terms should not be understood as limiting the present disclosure. In addition, the terms "first", "second" and "third" are used for distinguishing description only and cannot be understood as indicating or implying relative importance.

In addition, the terms "horizontal" and "vertical" do not mean that the components are required to be absolutely horizontal or overhanging, but may be slightly inclined. For example, "horizontal" only means that the direction is more horizontal relative to "vertical", and does not mean that the structure must be completely horizontal, but may be slightly inclined.

In the description of the present disclosure, it should be noted that the terms "arrangement", "installation", "connected" and "connection" should be understood in a broad sense unless otherwise specified and defined. For example, they may be fixed connection, removable connection or integrated connection; may be mechanical connection or electrical connection; and may be direct connection, or indirect connection through an intermediate medium, and connection inside two elements. The specific meanings of the above terms in the present disclosure may be understood in a specific case by those of ordinary skills in the art.

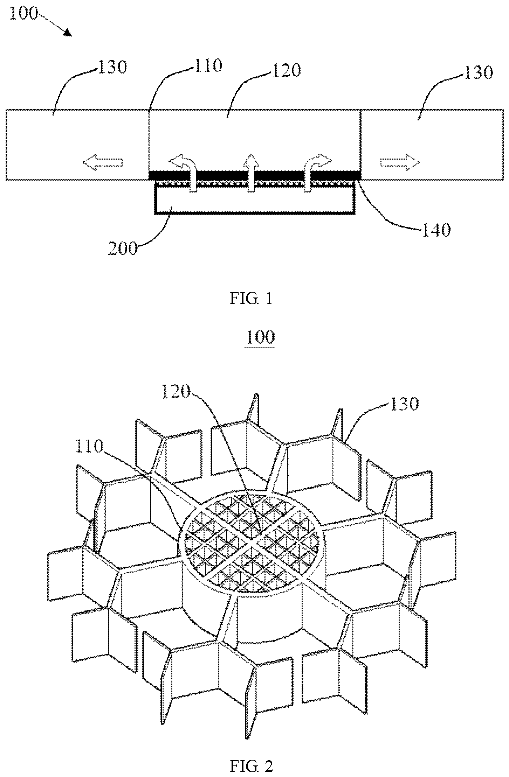

As shown in FIG. 1 to FIG. 3, an embodiment of the present disclosure provides a heat dissipation element 100. The heat dissipation element 100 may be configured to dissipate heat from a heat generating part of an electronic product, and has a good heat dissipation effect.

It should be pointed out that the heat dissipation element 100 provided by the embodiment of the present disclosure may be applied to various electronic devices, including but being not limited to a router and an acoustic enclosure. The embodiment of the present disclosure does not specifically require or limit a specific electronic device, and may be configured to dissipate heat from a processing chip or other heat generating parts 200 of the electronic device. Heat may be diffused from a center to an edge by using the heat dissipation element 100 provided by the embodiment of the present disclosure, which is beneficial for having a better heat dissipation effect.

In the embodiment of the present disclosure, the heat dissipation element 100 includes a body frame 110, inner ribs 120 and outer ribs 130. The body frame 110 encloses an inner space. The inner ribs 120 are connected with the body frame 110 to guide heat to the inner ribs 120 and divide the inner space into a plurality of heat dissipation holes, and the plurality of heat dissipation holes may uniformly and quickly transfer heat of the heat generating part 200 to the inner ribs 120 and further transfer the heat to the outer ribs 130, thus being beneficial for improving the heat dissipation effect. The outer ribs 130 are connected with the body frame 110 and extend in a direction away from the inner space, so that heat may be transferred to an area far away from the heat generating part 200, and radiation and convective heat exchange efficiencies can be improved by increasing a heat exchange area, thus improving a heat dissipation capacity.

It can be understood that in the embodiment of the present disclosure, the inner ribs 120 are located in the inner space enclosed by the body frame 110 and divide the inner space into the plurality of heat dissipation holes. The inner ribs 120 may be configured to be connected with the heat generating part 200 (such as a heat source chip) of the electronic device to transfer heat to the inner ribs 120. The plurality of heat dissipation holes may uniformly and quickly transfer the heat of the heat generating part 200 to the inner ribs 120 and further transfer the heat to the outer ribs 130, thus being beneficial for improving the heat dissipation effect. The outer ribs 130 extend in the direction away from the body frame 110, so that the heat may be transferred to the area far away from the heat generating part 200, and the radiation and convective heat exchange efficiencies can be improved by increasing the heat exchange area, thus improving the heat dissipation capacity.

In the embodiment, the body frame 110 encloses the inner space, and the body frame 110 is approximately formed as a ring, including but being not limited to a circular ring, a square ring or other irregular rings. As shown in the drawing, the body frame 110 is approximately formed as the circular ring, and the inner space enclosed by the body frame is correspondingly formed as a circle. A shape of the body frame 110 is similar to a shape of a body of the heat generating part 200, so that the body frame 110 is basically aligned with a center of the heat generating part 200, and the heat of the heat generating part is dissipated better.

It should be pointed out that when the heat dissipation element 100 is connected with the heat generating part 200 of the electronic device, such as a heat source chip of the electronic device. An interface material may be coated on the heat generating part 200, such as an interface material with a high heat conductivity including heat conductive silicone grease and a liquid metal. The heat dissipation element 100 is tightly attached to the heat generating part 200 through the interface material, which is beneficial for ensuring heat conduction and dissipation effects. Meanwhile, a substrate plate 140 may be arranged on the body frame 110, and the substrate plate 140 is connected with the body frame 110 and covers the plurality of heat dissipation holes. A bottom surface of the substrate plate 140 is contacted with the heat generating part 200 through the interface material coated on the heat generating part 200, so that the heat may be timely and uniformly transferred to the inner ribs 120. At the moment, a heat conduction path is the heat source chip (the heat generating part 200), the substrate plate 14, the body frame 110, the inner ribs 120 and the outer ribs 130 in sequence.

Optionally, the inner ribs 120 are provided at multi levels, each level of inner rib 120 is arranged in the inner space and divides the inner space into the plurality of heat dissipation holes, wherein an $(n+1)^{th}$ level of inner rib 120 is arranged in a heat dissipation hole enclosed by an $n^{th}$ level of inner rib 120 and the inner space, wherein n is a positive integer.

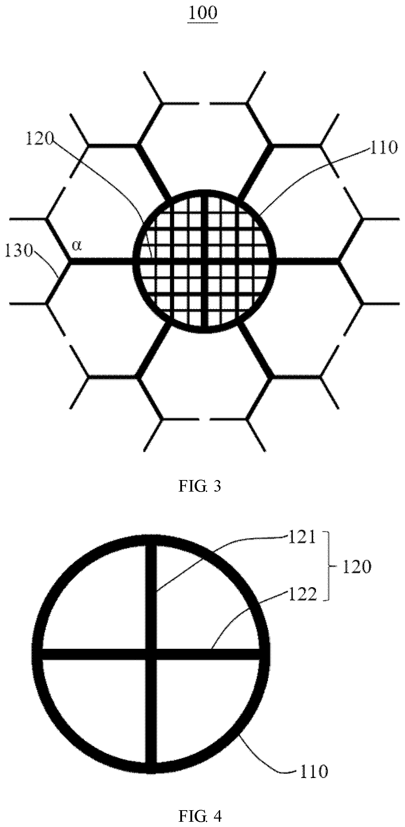

As shown in FIG. 4, further, each level of inner rib 120 includes a first rib 121 and a second rib 122 arranged in a crossed way, and each first rib 121 and each second rib 122 are connected with a higher-level inner rib 120 or the body frame 110.

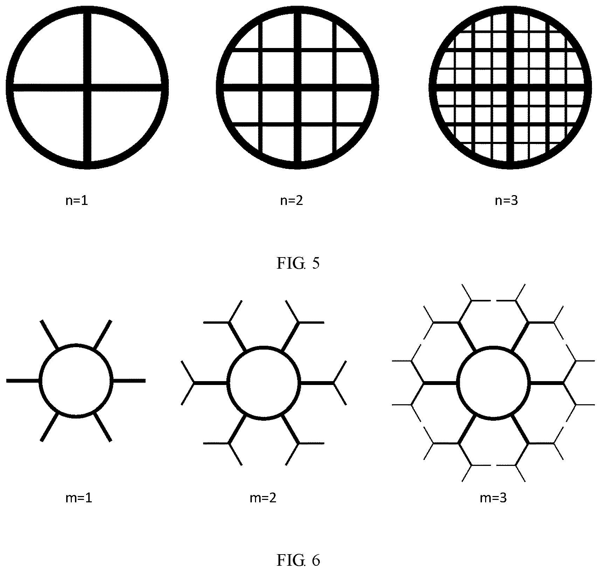

Optionally, the first rib 121 and the second rib 122 approximately form a right angle. As shown in FIG. 5, the body frame 110 is approximately the circular ring, and the first rib 121 and the second rib 122 approximately form the right angle. A first level of inner rib 120 may divide the circular inner space into four equal parts, which means that four heat dissipation holes are formed. A second level of inner rib 120 further divides each heat dissipation hole into four parts, and at the moment, the inner space is divided into sixteen heat dissipation holes. Further, a third level of inner rib 120 divides the inner space into sixty-four heat dissipation holes, and so on.

Optionally, a thickness of the inner rib 120 satisfies the following formula:

$$D_j = D_1 * k^{j-1}$$

wherein $D_j$ represents a thickness of a $j$th level of inner rib 120, $1 \leq j \leq n + 1$, $D_1$ represents a thickness of the first level of inner rib 120, and $k$ is a constant less than 1.

It should be pointed out that when the thickness of the inner rib 120 is set according to the above formula, a heat resistance of heat transfer between each level of inner rib 120 may be smaller, which is beneficial for improving a heat dissipation efficiency.

Optionally, the constant $k$ may be any value from 0 to 1. It can be found from researches of the inventor that, when k<1/3, although a number of levels of generated orthogonal ribs is large and the heat exchange area is large, a heat transfer resistance between horizontal ribs and a heat resistance of longitudinal ribs themselves are both greatly increased, resulting in reduction of the heat dissipation efficiency of the ribs; and when k>2/3, the heat transfer resistance is reduced, but a number of generated fractal levels is reduced, and the heat exchange area is reduced. When 1/3<k<2/3, the heat transfer resistance is relatively small, and sufficient number of levels of orthogonal ribs and sufficient heat exchange area are kept, so that a better heat dissipation effect may be achieved, thus being preferred. In the case that $k$ = 1/2, a best heat dissipation effect may be achieved, thus being further preferred Certainly, it is not limited to this. In other embodiments of the present disclosure, $k$ may be other values. The embodiment of the present disclosure does not have specific requirements and limitations on the value of $k$.

In the embodiment of the present disclosure, a heat exchange surface area can be increased by arranging the inner ribs 120, and the thickness of each level of inner rib 120 arranged at multi levels may be designed according to a bionics principle (which is namely the above thickness design formula for the inner ribs 120), thus further optimizing the heat dissipation path, reducing the heat resistance, increasing a heat response speed, and providing an effective solution for a heat dissipation problem of a high-power-consumption heat source chip in a limited space. Compared with traditional air cooling heat dissipation, the present disclosure has the advantages of no noise, no heat dissipation power consumption, less space requirement and simple system.

Optionally, the outer ribs 130 are provided at multi levels, a first level of outer rib 130 is connected with the body frame 110 and extends in a direction away from the body frame 110, an $(m+1)$th level of outer rib 130 is connected with one end of an $m$th level of outer rib 130 far away from the body frame 110, and the $(m+1)$th level of outer rib 130 and the $m$th level of outer rib 130 are arranged in a way of forming an angle, wherein $m$ is a positive integer.

Optionally, the outer ribs 130 are approximately formed as a tree and extend outwardly in sequence.

In the embodiment, multiple $m$th level of outer ribs 130 are provided, each $m$th level of outer rib 130 is connected with two $(m+1)$th level of outer ribs 130, and angles formed by the two $(m+1)$th level of outer ribs 130 and the $m$th level of outer rib 130 are equal.

That is to say, in this embodiment, a number of lower-level outer ribs 130 is twice that of higher-level outer ribs 130. Certainly, it is not limited to this. Optionally, each $m$th level of outer rib 130 may also be connected with more than two $(m+1)$th level of outer ribs 130. As shown in FIG. 6, when $m$ = 1, the first level of outer ribs 130 are connected with the body frame 110 at intervals, and extend in the direction away from the body frame 110. When $m$ = 2, the second level of outer rib 130 is connected with the first level of outer rib 130, and further extends in the direction away from the body frame 110, so that the heat is further far away from the body frame 110 and the heat generating part 200. When $m$ = 3, the third level of outer rib 130 is connected with the second level of outer rib 130, and further extends in the direction away from the body frame 110, so that the heat is further far away from the body frame 110 and the heat generating part 200.

Optionally, a length of the outer rib 130 may satisfy the following formula:

$$L_i = L_1 * A^{i-1}$$

wherein $L_i$ represents a length of an $i$th level of outer rib 130, $1 \leq i \leq m + 1$, $L_1$ represents a length of the first level of outer rib 130, and $A$ is a constant.

It should be pointed out that when the length of the outer rib 130 is set according to the above formula, a heat resistance of heat transfer between each level of outer rib may be smaller, which is beneficial for improving a heat dissipation efficiency. In the above formula, $A$ is a ratio of a length of a lower-level outer rib 130 to a length of a higher-level outer rib 130. It is found from researches of the inventor that, when $A$<1/2, the length of the outer rib 130 uniformly diffused to a periphery is limited, so that a heat transfer specific surface area cannot be effectively increased, and main heat dissipation requirement is only born by primary ribs, so that a heat dissipation performance is limited; and when $A>1$, the length of the lower-level rib is greater than that of the higher-level rib, so that a number of fractal levels of the outer ribs 130 in a limited space can be reduced, which means that a number of branches of the outer ribs 130 is reduced, an equivalent heat exchange area is greatly reduced, and the heat transfer resistance is also increased. When $1/2<A<1$, the length of the outer rib 130 uniformly diffused to the periphery and the number of levels are both appropriate, which ensures sufficient equivalent heat exchange area and moderate heat transfer resistance, so that the heat dissipation performance is excellent, thus being preferred.

Optionally, a thickness of the outer rib 130 may satisfy the following formula:

$$D_i = D_1 * B^{i-1}$$

wherein $D_i$ represents a thickness of an $i^{th}$ level of outer rib 130, $1 \le i \le m + 1$, $D_1$ represents a thickness of the first level of outer rib 130, and $B$ is a constant less than 1. It is found from researches of the inventor that, when $B<1/3$, a thickness of the lower-level outer rib 130 is reduced too fast and becomes very thin, which will greatly increase the heat transfer resistance of the outer rib 130, and the heat cannot be transferred to the lower-level outer rib 130 in time, which hinders heat transfer; and when $B>2/3$, the higher-level and lower-level outer ribs 130 are equal in width, but since a number of branches of the outer ribs 130 is increased, an equivalent heat conduction area is increasing, and the heat dissipation efficiency of the outer ribs 130 can be reduced by keeping the same thickness, resulting in unnecessary waste of materials. When $1/3<B<2/3$, a heat transfer resistance of the lower-level outer rib 130 is not increased too fast, and a heat dissipation capacity of the outer ribs 130 can be fully exerted and waste can be reduced, thus being preferred. When $B=1/2$, application requirements of most scenes can be satisfied, so that the heat resistance of the heat dissipation path is as low as possible, and the best heat transfer effect is achieved, thus being further preferred.

It should be pointed out that when the thickness of the outer rib 130 is set according to the above formula, a heat resistance of heat transfer between each level of outer rib may be smaller, which is beneficial for improving a heat dissipation efficiency. Meanwhile, it should be understood that in the thickness design of the outer ribs 130 and the inner ribs 120, the constants $k$ and $B$ may be set as equal constants or unequal constants.

Optionally, the thickness of the first level of inner rib 120, the thickness of the body frame 110 and the thickness of the first level of outer rib 130 may be equal, and the above constants $k$ and $B$ may also be set as equal constants less than 1.

Optionally, an angle formed by the $(m+1)^{th}$ level of outer rib 130 and the $m^{th}$ level of outer rib 130 satisfies the following formula:

$$\alpha \ge (180 - 360/C)°$$

wherein $a$ represents the angle formed by the $(m+1)^{th}$ level of outer rib 130 and the $m^{th}$ level of outer rib 130, $C$ represents a number of the $(m+1)^{th}$ level of outer rib 130.

It should be understood that the angle $\alpha$ and the number of branches of the outer ribs 130 in a shape of tree at the periphery may be appropriately adjusted to prevent the outer ribs 130 at tail ends from crossing. The larger the length ratio of the outer fins 130 is, the larger the number of levels is, and the larger the extension range at the periphery is. The above parameters may be determined according to an actual heat dissipation space.

An embodiment of the present disclosure provides an electronic device, which includes the heat dissipation element 100 according to any one of the items above

As shown in FIG. 1 to FIG. 6, according to the heat dissipation element 100 and the electronic device provided by the embodiments of the present disclosure: the inner ribs 120 are located in the inner space enclosed by the body frame 110 and divide the inner space into the plurality of heat dissipation holes. The inner ribs 120 may be configured to be connected with the heat generating part 200 of the electronic device to transfer heat to the inner ribs 120. The plurality of heat dissipation holes may uniformly and quickly transfer the heat of the heat generating part 200 to the inner ribs 120 and further transfer the heat to the outer ribs 130, thus being beneficial for improving the heat dissipation effect. The outer ribs 130 extend in the direction away from the body frame 110, so that the heat may be transferred to the area far away from the heat generating part 200, and the radiation and convective heat exchange efficiencies can be improved by increasing the heat exchange area, thus improving the heat dissipation capacity.

The foregoing is only the preferred embodiments of the present disclosure and is not intended to limit the present disclosure. For those skilled in the art, the present disclosure may have various modifications and changes. Any modification, equivalent replacement, or improvement made within the spirit and principle of the present disclosure should fall within the scope of protection of the present disclosure.

## INDUSTRIAL APPLICABILITY

The heat dissipation element and the electronic device provided by the embodiments of the present disclosure are beneficial for improving the heat dissipation effect, may transfer the heat to the area far away from the heat generating part, and can improve the radiation and convective heat exchange efficiencies by increasing the heat exchange area, thus improving the heat dissipation capacity.

**Claims**

1. A heat dissipation element, comprising a body frame, inner ribs and outer ribs, wherein the body frame encloses an inner space, the inner ribs are connected with the body frame and divide the inner space into a plurality of heat dissipation holes, and the outer ribs are connected with the body frame and extend in a direction away from the inner space.

2. The heat dissipation element according to claim 1, wherein the inner ribs are provided at multi levels, each level of inner rib is arranged in the inner space and divides the inner space into the plurality of heat dissipation holes, wherein an $(n+1)^{th}$ level of inner rib is arranged in a heat dissipation hole enclosed by an $n^{th}$ level of inner rib and the inner space, wherein n is a positive integer.

3. The heat dissipation element according to claim 2, wherein each level of inner rib comprises a first rib and a second rib arranged in a crossed way, and each first rib and each second rib are connected with a higher-level inner rib or the body frame.

4. The heat dissipation element according to claim 2 or 3, wherein a thickness of the inner rib satisfies the following formula:

$$D_j = D_1 * k^{j-1}$$

wherein $D_j$ represents a thickness of a $j^{th}$ level of inner rib, $1 \leq j \leq n + 1$, $D_1$ represents a thickness of a first level of inner rib, and $k$ is a constant less than 1.

5. The heat dissipation element according to claim 4, wherein a range of $k$ is that 1/3<k<2/3.

6. The heat dissipation element according to any one of claims 1 to 5, wherein the outer ribs are provided at multi levels, a first level of outer rib is connected with the body frame and extends in a direction away from the body frame, an $(m+1)^{th}$ level of outer rib is connected with one end of an $m^{th}$ level of outer rib far away from the body frame, and the $(m+1)^{th}$ level of outer rib and the $m^{th}$ level of outer rib are arranged in a way of forming an angle, wherein $m$ is a positive integer.

7. The heat dissipation element according to claim 6, wherein multiple $m^{th}$ level of outer ribs are provided, each $m^{th}$ level of outer rib is connected with two

$(m+1)^{th}$ level of outer ribs, and angles formed by the two $(m+1)^{th}$ level of outer ribs and the $m^{th}$ level of outer rib are equal.

8. The heat dissipation element according to claim 6 or 7, wherein a length of the outer rib satisfies the following formula:

$$L_i = L_1 * A^{i-1}$$

wherein $L_i$ represents a length of an $i^{th}$ level of outer rib, $1 \leq i \leq m + 1$, $L_1$ represents a length of a first level of outer rib, and $A$ is a constant.

9. The heat dissipation element according to claim 8, wherein a range of $A$ is that 1/2<A<1.

10. The heat dissipation element according to claim 6 or 7, wherein a thickness of the outer rib satisfies the following formula:

$$D_i = D_1 * B^{i-1}$$

wherein $D_i$ represents a thickness of an $i^{th}$ level of outer rib, $1 \leq i \leq m + 1$, $D_1$ represents a thickness of a first level of outer rib, and $B$ is a constant less than 1.

11. The heat dissipation element according to claim 10, wherein a range of $B$ is that 1/3<B<2/3 .

12. The heat dissipation element according to claim 6 or 7, wherein an angle formed by the $(m+1)^{th}$ level of outer rib and the $m^{th}$ level of outer rib satisfies the following formula:

$$\alpha \geq (180 - 360/C)°$$

wherein $a$ represents the angle formed by the $(m+1)^{th}$ level of outer rib and the $m^{th}$ level of outer rib, $C$ represents a number of the $(m+1)^{th}$ level of outer rib.

13. The heat dissipation element according to any one of claims 1 to 12, wherein a shape of the body frame is similar to a shape of a body of a heat generating part.

14. The heat dissipation element according to any one of claims 1 to 12, wherein the body frame is approximately formed as a ring.

15. The heat dissipation element according to claim 14, wherein the body frame is approximately formed as a circular ring, and the inner space enclosed by the body frame is correspondingly formed as a circle.

16. An electronic device, comprising the heat dissipation element according to any one of claims 1 to 15.

17. The electronic device according to claim 16, wherein a substrate plate is arranged on the body frame, and the substrate plate is connected with the body frame and covers the plurality of heat dissipation holes.

18. The electronic device according to claim 16 or 17, wherein an interface material with a high heat conductivity is coated on a heat generating part of the electronic device.

19. The electronic device according to claim 18, wherein a bottom surface of the substrate plate is contacted with the heat generating part through the interface material coated on the heat generating part.

20. The electronic device according to claim 18 or 19, wherein the interface material is a heat conductive silicone grease or a liquid metal.

100

FIG. 1

100

FIG. 2

<u>100</u>

FIG. 3

FIG. 4

FIG. 5

FIG. 6

## INTERNATIONAL SEARCH REPORT

| International application No. |
| --- |
| **PCT/CN2021/087911** |

**A. CLASSIFICATION OF SUBJECT MATTER**

H05K 7/20(2006.01)i

According to International Patent Classification (IPC) or to both national classification and IPC

**B. FIELDS SEARCHED**

Minimum documentation searched (classification system followed by classification symbols)

H05K7/20, F21V, F21S, G06F1/20, H01L23/-

Documentation searched other than minimum documentation to the extent that such documents are included in the fields searched

Electronic data base consulted during the international search (name of data base and, where practicable, search terms used)

CNABS, CNTXT, CNKI, VEN, WOTXT, USTXT, EPTXT: 散热, 导热, 传热, 热传导, 肋, 鳍片, 翅片, 放射, 分形, 分型, 分叉, 树, 交叉, 间隔, 孔, 空腔, heat, dissipate, conduct, transfer, rib, fin, fractal, bifurcate, tree, intersect, spacing, hole, cavity

**C. DOCUMENTS CONSIDERED TO BE RELEVANT**

| Category* | Citation of document, with indication, where appropriate, of the relevant passages | Relevant to claim No. |
| --- | --- | --- |
| X | CN 102563575 A (JIN, Songshan) 11 July 2012 (2012-07-11) description, paragraphs [0025]-[0034], and figures 1-6 | 1, 13-20 |
| Y | CN 102563575 A (JIN, Songshan) 11 July 2012 (2012-07-11) description, paragraphs [0025]-[0034], and figures 1-6 | 6, 7 |
| Y | CN 101394730 A (BEIHANG UNIVERSITY) 25 March 2009 (2009-03-25) description specific embodiments paragraphs 1-6, figures 1-4 | 6, 7 |
| A | CN 102034773 A (SOUTHEAST UNIVERSITY) 27 April 2011 (2011-04-27) entire document | 1-20 |
| A | CN 203115915 U (GUANGZHOU LEDIA LIGHTING TECHNOLOGY CO., LTD.) 07 August 2013 (2013-08-07) entire document | 1-20 |
| A | JP 61285636 A (NEW JAPAN RADIO CO., LTD.) 16 December 1986 (1986-12-16) entire document | 1-20 |

☐ Further documents are listed in the continuation of Box C.   ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **11 October 2021** | **18 October 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/087911**

| Patent document cited in search report | | | Publication date (day/month/year) | Patent family member(s) | | | Publication date (day/month/year) |
|---|---|---|---|---|---|---|---|
| CN | 102563575 | A | 11 July 2012 | None | | | |
| CN | 101394730 | A | 25 March 2009 | None | | | |
| CN | 102034773 | A | 27 April 2011 | CN | 102034773 | B | 04 July 2012 |
| CN | 203115915 | U | 07 August 2013 | None | | | |
| JP | 61285636 | A | 16 December 1986 | JP | H0467736 | B2 | 29 October 1992 |
| | | | | JP | S61285636 | A | 16 December 1986 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2021101448405